## Europäisches Patentamt

## European Patent Office

## Office européen des brevets

(19)

(11) Publication number: **0 153 178**
**B1**

(12) **EUROPEAN PATENT SPECIFICATION**

(45) Date of publication of patent specification: **17.08.88**

(51) Int. Cl.⁴: **G 09 G 3/34,** G 06 F 1/00

(21) Application number: **85301049.4**

(22) Date of filing: **18.02.85**

(54) An electric display apparatus.

(30) Priority: **17.02.84 JP 29396/84**
**17.02.84 JP 29397/84**

(43) Date of publication of application:
**28.08.85 Bulletin 85/35**

(45) Publication of the grant of the patent:
**17.08.88 Bulletin 88/33**

(84) Designated Contracting States:
**DE FR GB**

(56) References cited:
**FR-A-2 514 537**
**US-A-4 160 583**

**PATENTS ABSTRACTS OF JAPAN, vol. 8, no.**
**18 (P-250)1455r, 26th January 1984.**

(73) Proprietor: **DAIWA SHINKU CORPORATION**
**1389 Shinzaike-Kono Hiraoka-cho**
**Kakogawa Hyogo 675-01 (JP)**

(72) Inventor: **Togo, Hidehiko**
**1363-4 Shinzaike Hiraoka-cho**
**Kakogawa Hyogo 675-01 (JP)**
Inventor: **Azumi, Yoshiaki**
**1481 Shinobe Befu-cho**
**Kakogawa Hyogo 675-01 (JP)**

(74) Representative: **Jackson, David Spence et al**
**REDDIE & GROSE 16, Theobalds Road**
**London, WC1X 8PL (GB)**

## Description

The present invention relates to display apparatus comprising electrically operable display means, display control and driving circuitry, and detachable memory means connectable to the control and driving circuitry and storing display information.

FR—A—2 514 537 discloses a display apparatus of the kind defined hereinbefore at the beginning which is in the form of a portable automatic information system using a detachably constituted replaceable memory formed by a permanent memory device, which preferably is a ROM. The system of FR—A—2 514 537 is designed to display a set of "static" information items stored in one of separately prepared replaceable ROMs, and has a processor, preferably a microprocessor, arranged to read out the display information from the connected ROM, and to supply corresponding display control signals to a display device such as a liquid crystal display.

From US—A—4 160 583 there is known an electrostatic display unit which basically consists of a fixed electrode, a movable electrode and an insulating layer which prevents the electrodes from being short-circuited when the moving electrode moves towards the fixed electrode. When a high voltage is applied between the electrodes, an electrostatic force pulls and bends the movable electrode so as to cover the fixed electrode. Thus the display unit has its appearance changed by the electrostatic force.

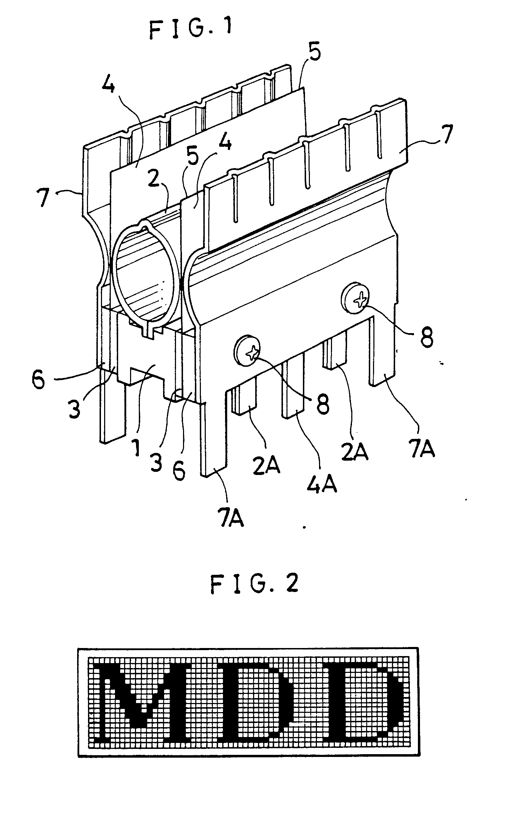

An example of such an electrostatic display unit is shown in Fig. 1. In the figure a cylindrical inner fixed electrode 2 is mounted on a base 1. On both sides of the base 1 are fixed two film holders 3, 3 by which two film-like movable electrodes 4, 4 are held extending upward with their upper portions having free edges 5, 5. On the outer sides of the film holders 3, 3 two outer fixed electrodes 7, 7 are mounted with spacers 6, 6 inserted. The outer fixed electrodes 7, 7 have semi-cylindrical middle portions which protrude inward. The base 1, the film holders 3, 3, lower portions of the movable electrodes 4, 4, the spacers 6, 6 and lower portions of the outer electrodes 7, 7 are all fixed together by screw bolts 8, 8. The outer surface of the inner fixed electrode 2 and the inner surfaces of the outer fixed electrodes 7, 7 are coated with insulating paints of respective particular colors. The two surfaces of the movable electrodes 4, 4 are mirror-finished. Further, the inner fixed electrode 2, the film holders 3, 3 and the outer fixed electrodes 7, 7 have their lowermost ends fabricated so as to provide respective terminals 2A, 4A and 7A.

If a voltage is applied between the terminals 4A and 7A, the movable electrodes 4, 4 open outward to fully expose the inner fixed electrode 2. Consequently, the display unit seen from above has the color applied to the inner fixed electrode 2. With a voltage applied between the terminals 4A and 2A, the movable electrodes 4, 4 are bent so as to cover the surface of the inner fixed electrode 2, and consequently the color of the display unit changes to that applied to the inner surfaces of the outer fixed electrodes 7, 7.

An electrostatic display apparatus can be constituted by a large number of such electrostatic display units arranged so as to form a matrix. Fig. 2 shows an example of the pattern dot-displayed on such a display apparatus. The display apparatus can be made to display not only a static pattern but also a moving or a flowing pattern by shifting the display information at a constant speed or varying the display information gradually.

In some cases, however, it is desired to delete some parts of a display or to replace them with other kinds of display information.

An object of the present invention is to provide apparatus capable of easily changing part of the display information supplied to an electrostatic display apparatus without interrupting display.

Another object of the present invention is to provide means for making it possible to stock many pieces of display information easily and safely.

According to the present invention display apparatus of the kind defined hereinbefore at the beginning is characterised in that the display means comprises a matrix of electrostatic display units, each display unit having a fixed electrode, a resilient movable electrode held in the vicinity of the fixed electrode, a dielectric layer on the surface of either or both the fixed and movable electrodes, and means for applying voltage between the fixed and movable electrodes whereby the appearance of the unit can be changed by changing the voltage applied, the movable electrode being electrostatically movable so as to cover or reveal the surface of the fixed electrode, in that the display units are supplied voltage through switching elements of a display unit driving circuit operated by outputs from shift register means arranged to store and shift display data supplied thereto from the memory means, and in that the memory means comprises one or more RAM devices each having a respective circuit board detachably connectable to the control and driving circuitry and having a respective back-up battery mounted on the respective circuit board, whereby the display information from which the display means is driven can be changed by selection of the number and combination of RAM devices forming the memory means.

The present invention is further described in detail in the following with reference to the attached drawings, in which:

Fig. 1 shows a perspective view of an electrostatic display unit used in an embodiment of the present invention;

Fig. 2 shows an example of pattern display;

Fig. 3 shows a block diagram illustrating the constitution of an embodiment of the present invention;

Fig. 4 shows an example of the RAM control circuit in Fig. 3;

Fig. 5 is a drawing illustrating the operation of the above embodiment;

Fig. 6 shows a circuit of a separate RAM used in the above embodiment;

Fig. 7 shows a perspective outer view of the above separate RAM; and

Fig. 8 shows a shorter terminal corresponding to the chip enable terminal of the RAM.

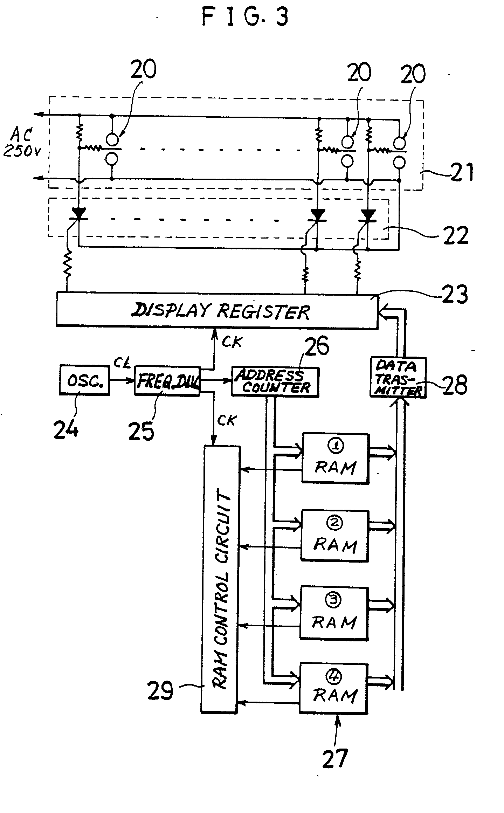

In Fig. 3, a display panel 21 is constituted with many electrostatic display units 20 (each as shown in perspective in Fig. 1) arranged to form a matrix. The number of display units is, for example, 20×200. A display unit driving circuit 22 is made up of many thyristors, each of which corresponds to a respective one of the display units 20. A display register 23 consists of shift registers set to form a matrix in correspondence with the display units 20, and is shift-driven by clock pulses CK which are produced by the dividing of the output frequency CL of an oscillator 24 by a frequency divider 25. The dividing step varies according to display instruction codes $C_1$, $C_2$ mentioned below, so the frequency of the clock pulses CK depends on the codes. The clock pulses CK drive an address counter 26 for RAMs 27. The RAMs 27 are assembled on separate circuit boards according to the contents of their display information. Each of the circuit boards is made detachable from the main part of the circuitry by means of a multi-connector. The contents stored in the RAMs 27 are transmitted to the display register 23 column by column by a data transmitter 28. The contents of the separate RAMs are read out in the order ①→②→③→④. However, if the RAM ② is put off, they are read out in the order ①→③→④ with the part ② jumped over. The sequence of reading out is controlled by a RAM control circuit 29.

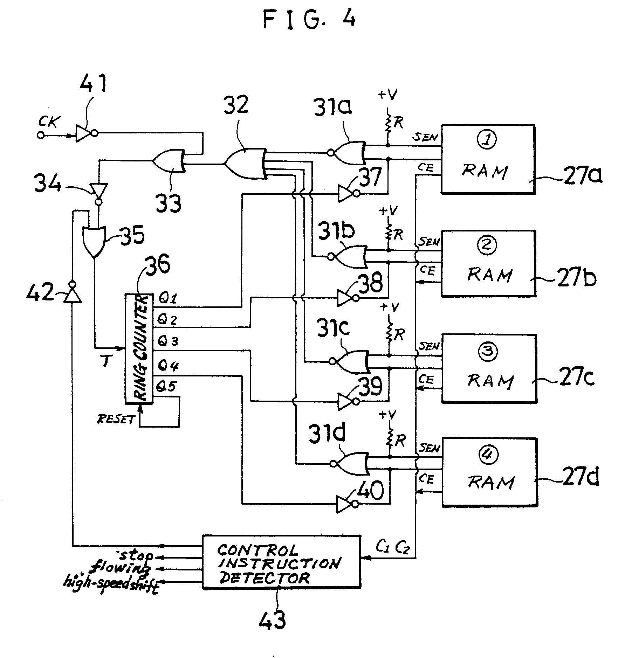

Fig. 4 shows an example of the RAM control circuit 29. Each RAM has a terminal SEN which allows detection of whether the circuit board of that RAM is connected to the main circuitry. The terminals SEN themselves are grounded within the respective circuit board, while the lines connected to the terminal SEN are supplied with plus voltages +V through respective resistors R within the main circuitry. Hence the line connected to the terminal SEN when the corresponding RAM is present and connected is kept at low level (L), but turns to a high level (H) when the RAM is disconnected. A RAM chip enable terminal CE is at the low level (L) if the corresponding RAM is in an active state, and at the high level (H) if the RAM is in a self-holding state. Of the four RAMs, only one is in an active state at any one time. NOR gates 31a, 31b, 31c and 31d serve to detect that the corresponding RAMs are engaged and in an active state. If an OR gate 32 detects that all of the four NOR gates 31a to 31d output L-levels, it outputs L-level. An OR gate 33 passes the clock signal CK if the OR gate 32 outputs L-level and blocks the clock signal CK if the OR gate 32 outputs a H-level. The output from the OR gate 33 is inputted to an OR gate 35 through an inverter 34. The OR gate 35 executes the OR function with a return signal indicating the completion of data of the RAM which was in an active state and a clock signal CK received through the inverter 34 as inputs. The return signal serves as a count-up signal to a ring counter 36. According to the output T from the OR gate 35, the ring counter 36 sets its output terminals at H-level successively in the order $Q_1$ → $Q_2$ → ... → $Q_5$ → $Q_1$. The output terminals $Q_1$, ..., $Q_4$ are connected to the chip enable terminals of the RAMs ① to ④ through inverters 37, ..., 40, respectively. Control instruction codes $C_1$, $C_2$ are written in each of the RAMs together with the display data. The control instruction codes specify, as is shown in the table below, the flowing display mode, the high-speed shift mode, the stop mode and the return mode. The return mode is written just after the last data in the separate RAMs. In Fig. 4, reference numbers 41 and 42 indicate

| $C_1$ | $C_2$ | Mode |
|-------|-------|------|
| 0 | 0 | Flowing display |
| 1 | 0 | High-speed shift |
| 0 | 1 | Stop |
| 1 | 1 | Return |

inverters.

The operation of the above embodiment is described in the following.

Suppose that the first RAM 27a is in an active state. As the output of the first NOR gate 31a is at H-level, the OR gates 32 and 33 output H-levels, so the clock pulse CK is masked and cannot be detected. In this case the inverter 34 output is at L-level, so the OR gate 35 is ready to detect the return signal of a control instruction. On the ending of the last data of the first RAM 27a, a control instruction detector 43 detects the return code and outputs the return signal.

Accordingly, the ring counter 36 sets the chip enable terminal CE of the second RAM 27b at L-level, and at the same time it causes the terminal CE of the first RAM 27a to return to H-level.

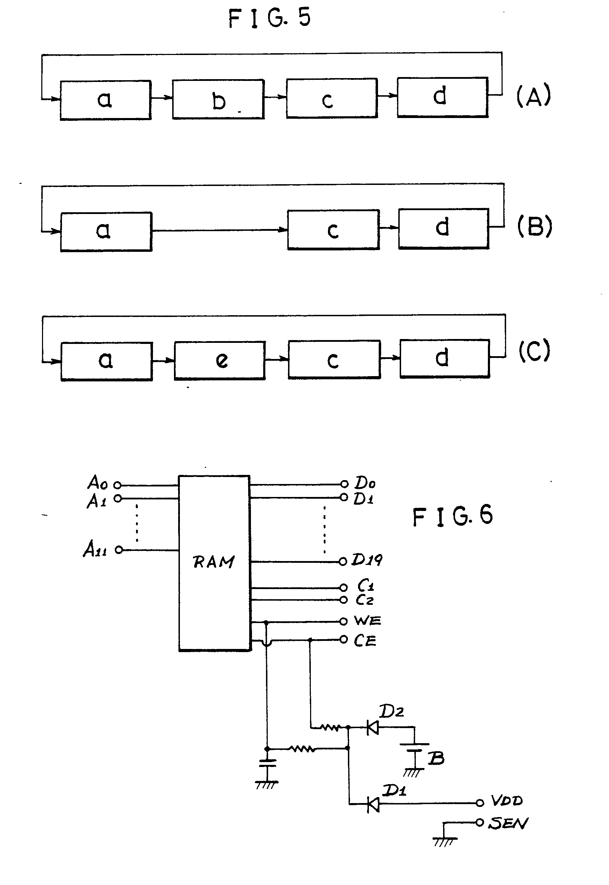

Therefore, if the second RAM 27b has been connected in at this stage, the second NOR gate 31b outputs H-level, so the OR gate 35 again becomes ready to detect the return signal. In such a manner the RAMs 27a, 27b, 27c and 27d are, if all connected in, put into an active state successively in the order a → b → c → d → a → ..., as shown in Fig. 5(a), and the information in the RAMs is read out.

If again the first RAM 27a is an active state, data is read out from the RAM 27a until the return signal from the first RAM 27a is detected, and then the ring counter 36 outputs $Q_2$. However, if the second RAM 27b is disconnected, the NOR

gate 31b outputs L-level irrespective of the level at its input for connection to the chip enable terminal CE of the RAM 27b, because its other input turns to H-level. Then all the four NOR gate 31a to 31d output L-level, so the output of OR gate 32 also turns to L-level and the OR gate 33 becomes ready to detect the clock signals CK. The clock signals are continually outputted, so the output of the ring counter 36 proceeds from $Q_2$ to $Q_3$. If the third RAM 27c is connected in at this stage the output of the OR gate 33 is again kept at H-level to mask the clock signal CK, and the OR gate 35 becomes ready to detect the return instruction from the third RAM 27c. The address of the RAM not engaged in the connector is thus jumped over. Fig. 5(B) shows the order of reading out the data when only the second RAM 27b is disconnected. Further, if a fifth RAM 27e (not shown in Fig. 4) is inserted in the connector as a replacement for the second RAM 27b, that is, the second RAM 27b is replaced by the fifth RAM 27e, the data are read out in the order a → e → c → d → a → ..., as shown in Fig. 5(C). As Fig. 5(C) shows, the display data can be partially changed simply by replacing a RAM.

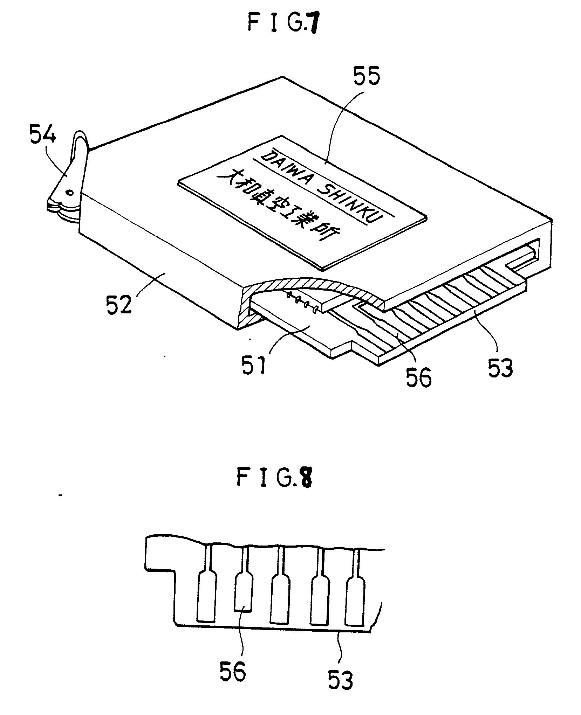

Fig. 6 shows a circuit provided on a RAM circuit board and hence detachable from the main circuitry. The RAM has address specifying terminals $A_0$, ..., $A_{11}$, display data output terminals $D_0$, ..., $D_{19}$, control instruction code terminals $C_1$, $C_2$, a write enable terminal WE and a chip enable terminal CE. In addition to these terminals, the circuit board is further provided with a D.C. power source terminal VDD and a mounting detection terminal SEN. The RAM is supplied from an external power source through the D.C. power source terminal VDD coupled through a diode $D_1$. In addition back-up power is supplied from a back-up battery B on the circuit board through a diode $D_2$. The diode $D_2$ becomes conducting when the circuit board is detached from the connector, because the external voltage VDD is cut off. With the circuit board connected to the connector, only the external voltage is supplied, since the diode $D_2$ is non-conducting because the voltage of the battery B is lower than the external voltage VDD.

Fig. 7 shows a partially cut-away perspective view of a package 52 containing a circuit board 51. The circuit board 51, which is protected by the package 52, has its terminals 53, 56 inserted in a multi-connector. A lever 54 attached to the package 52 is used for disconnecting the circuit board. On the outer surface of the package, a name plate 55 can be applied to indicate the title, the pattern to be displayed, and other information.

In the present embodiment, it is an important feature that, as shown in Fig. 8, the chip enable terminal 56 alone is made shorter than other terminals. This causes the chip enable terminal 56 to be disconnected prior to other terminals when the circuit board is detached from the multi-connector. Then the RAM is self-energized. When the circuit board is inserted in the multi-connector, the chip enable terminal 56 is connected after other terminals, and the self energizing ceases after the power source connection. Therefore, the contents of the RAM can be protected from being damaged by noise, even if the circuit board is detached without cutting off the power source.

**Claims**

1. Display apparatus comprising electrically operable display means (21), display control and driving circuitry (22—26, 28, 29), and detachable memory means (27) connectable to the control and driving circuitry (22—26, 28, 29) and storing display information, characterised in that the display means (21) comprises a matrix of electrostatic display units (20), each display unit having a fixed electrode (2, 7), a resilient movable electrode (4) held in the vicinity of the fixed electrode (2, 7), a dielectric layer on the surface of either or both the fixed and movable electrodes, and means for applying voltage between the fixed and movable electrodes whereby the appearance of the unit can be changed by changing the voltage applied, the movable electrode (4) being electrostatically movable so as to cover or reveal the surface of the fixed electrode (2, 7), in that the display units (21) are supplied voltage through switching elements of a display unit driving circuit (22) operated by outputs from shift register means (23) arranged to store and shift display data supplied thereto from the memory means (27), and in that the memory means (27) comprises one or more RAM devices (27a, 27b, 27c, 27d) each having a respective circuit board (51) detachably connectable to the control and driving circuitry (22—26, 28, 29) and having a respective back-up battery (B) mounted on the respective circuit board (51), whereby the display information from which the display means (21) is driven can be changed by selection of the number and combination of RAM devices forming the memory means (27).

2. Display apparatus according to claim 1, characterised in that each RAM device (27a, 27b, 27c, 27d) has on its respective circuit board (51) a chip enable terminal (56) which is shorter than other terminals (53) on the board (51).

**Patentansprüche**

1. Anzeigegerät mit elektrisch betätigbaren Anzeigeeinrichtungen (21), einem Anzeige-Steuerungs- und Antriebsstromkreis (22—26, 28, 29) und abtrennbaren Speichereinrichtungen (27), die mit dem Steuerungs- und Abtriebsstromkreis (22—26, 28, 29) verbunden werden können und Anzeigeinformationen speichern, dadurch gekennzeichnet, daß zu der Anzeigeeinrichtung (21) eine Matrix von elektrostatischen Anzeigeeinheiten (20) gehört, wobei jede Anzeigeeinheit eine feste Elektrode (2, 7) aufweist, eine elastische bewegliche Elektrode (4) in der Nähe der festen Elektrode (2, 7), eine dielektrische Schicht auf der

Oberfläche entweder der festen oder der beweglichen oder beider Elektroden sowie Einrichtungen zum Aufbringen einer Spannung zwischen der festen und der beweglichen Elektrode, wobei das Erscheinungsbild der Einheit durch Ändern der aufgebrachten Spannung geändert werden kann, da die bewegliche Elektrode (4) elektrostatisch in der Weise beweglich ist, daß sie die Oberfläche der festen Elektrode (2, 7) abdeckt oder freigibt, daß den Anzeigeeinheiten (21) Spannung durch Schaltelemente eines Anzeigeeinheit-Antriebsstromkreises (22) zugeführt wird, der durch die Ausgangssignale von Schieberegistereinrichtungen (23) betätigt wird, die so eingerichtet sind, daß sie Anzeigedaten speichern und verschieben, die ihnen von den Speichereinrichtungen (27) her zugeführt werden, und daß zu den Speichereinrichtungen (27) eine oder mehrere Speichereinrichtungen mit direktem Zugriff (27a, 27b, 27c, 27d) gehören, die jeweils eine Schaltungsplatte (51) aufweisen, die mit dem Steuerungs- und Antriebsstromkreis (22—26, 28, 29) lösbar verbunden werden kann und jeweils eine Zusatzbatterie (B) aufweist, die auf der betreffenden Schaltungsplatte (51) montiert ist, so daß die Anzeigeinformation, gemäß welcher die Anzeigeeinrichtung (21) betrieben wird, durch Wählen der Anzahl und Kombination von Speichereinrichtungen mit direktem Zugriff, die die Speichereinrichtung (27) bilden, verändert werden kann.

2. Anzeigegerät nach Anspruch 1, dadurch gekennzeichnet, daß jede Speichereinrichtung mit direktem Zugriff (27a, 27b, 27c, 27d) an ihrer zugehörigen Schaltungsplatte (51) eine Chipsteuerklemme (56) aufweist, die kürzer ist als die anderen auf der Platte (51) vorhandenen Klemmen (53).

**Revendications**

1. Appareil d'affichage comprenant des moyens d'affichage (21) pouvant être actionnés électriquement, un circuit d'alimentation et de commande d'affichage (22—26, 28, 29), et des moyens à mémoire amovibles (27) pouvant être connectés au circuit d'alimentation et de commande (22—26, 28, 29) et mémorisant de l'information à afficher, caractérisé en ce que les moyens d'affichage (21) comprennent une matrice d'unités d'affichage électrostatiques (20), dont chacune comporte une électrode fixe (2, 7), une électrode élastique mobile (4) maintenue au voisinage de l'électrode fixe (2, 7), une couche diélectrique prévue sur la surface de l'une ou l'autre ou des deux électrodes fixe et mobile, et des moyens pour appliquer une tension entre les électrodes fixe et mobile, de sorte que l'aspect de l'unité peut être modifié en changeant la tension appliquée, l'électrode mobile (4) étant mobile de façon électrostatique de manière à couvrir ou à découvrir la surfaec de l'électrode fixe (2, 7), en ce que les unités d'affichage (21) sont alimentées en tension par l'intermédiaire d'éléments de commutation d'un circuit (22) d'attaque d'unités d'affichage actionné par les sorties de moyens (23) à registre à décalage agencés pour mémoriser et décaler des données d'affichage qui leur sont appliquées à partir des moyens à mémoire (27), et en ce que les moyens à mémoire (27) comprennent un ou plusieurs dispositifs à RAM (27a, 27b, 27c, 27d), comprenant chacun une carte de circuit respective (51) pouvant être connectée de façon amovible au circuit d'attaque et de commande (22—26, 28, 29) et comprenant une pile de secours respective (B) montée sur la carte de circuit respective (51), de sorte que l'information à afficher avec laquelle les moyens d'affichage sont attaqués puisse être changée par une sélection du nombre et de la combinaison de dispositifs à RAM formant les moyens à mémoire (27).

2. Dispositif d'affichage suivant la revendication 1, caractérisé en ce que chaque dispositif à mémoire (27a, 27b, 27c, 27d) comporte, sur sa carte de circuit respective (51), une borne de déclenchement de pastille (56), plus courte que les autres bornes (53) prévues sur la carte (51).

## FIG. 1

## FIG. 2

## F I G. 3

FIG. 4

F I G. 5

(A)

(B)

(C)

F I G. 6

4

# F I G.7

# F I G.8